# EUROPÄISCHE PATENTSCHRIFT

(11) **EP 1 987 169 B1**
(45) Veröffentlichungstag und Bekanntmachung des Hinweises auf die Patenterteilung: **31.08.2011**
(21) Anmeldenummer: 07711524.4
(22) Anmeldetag: 13.02.2007
(51) Int. Cl.: C22C 5/02, C22C 1/02, H01L 23/49

(54) **Verfahren zur Herstellung einer Goldlegierung**
Method of manufacturng a gold alloy
Procédé der fabrication une alliage d'or

(30) Priorität: 13.02.2006 DE 102006006782
(43) Veröffentlichungstag der Anmeldung: 05.11.2008
(73) Patentinhaber: W.C. Heraeus GmbH, 63450 Hanau (DE)
(72) Erfinder: BISCHOFF, Albrecht, 63486 Bruchköbel (DE); SCHRAEPLER, Lutz, 13156 Berlin (DE); ZINGG, Holger, 63599 Biebergemünd (DE)
(74) Vertreter: Kühn, Hans-Christian
(86) Internationale Anmeldenummer: PCT/EP2007/001233
(87) Internationale Veröffentlichungsnummer: WO 2007/093380

(56) Entgegenhaltungen:
- EP-A1- 0 761 831
- EP-A1- 0 822 264
- EP-A1- 0 922 780
- GB-A- 2 116 208
- JP-A- 5 009 624

## Beschreibung

Die vorliegende Erfindung bezieht sich auf ein Verfahren zur Herstellung einer homogenen Goldlegierung enthaltend Calcium mit hoher Festigkeit.

Im Zuge der ständigen Miniaturisierung der Halbleiterbauteile und einem damit einhergehenden Bestreben nach Verringerung des Gold-Bonddrahtdurchmessers werden zunehmende Anforderungen an die Festigkeit des Drahtes und die Zuverlässigkeit der Drahtverbindungen (Loops) gestellt. Bekannt sind insbesondere Dotierungen mit Elementen der zweiten Hauptgruppe des Periodensystems (Erdalkalimetalle), wie z.B. mit Beryllium und Kalzium gemäß C. W. Conti, Gold Bulletin, 1999, 32(2) 39 oder Yuantao Ning, Gold Bulletin, 2001, 34(3) 77. Auch Lanthanoide, wie beispielsweise Europium und Ytterbium werden als Dotierungselemente zugesetzt. Problematisch an den Lanthanoiden ist deren Löslichkeit in der Goldmatrix. Die schlechte Löslichkeit von Lathanoiden in der Goldmatrix führt zu Inhomogenitäten und im ungünstigsten Fall zu groben Ausscheidungen im Goldstrang, insbesondere bei Europium und Ytterbium. Statt einer Festigkeitssteigerung kann somit auch das Gegenteil bewirkt werden, indem die Dotierung versprödend wirkt bzw. die Drahtziehbarkeit behindert. Bei den Elementen der zweiten Hauptgruppe, wie z.B. Kalzium, kann mit zunehmender Dotierungskonzentration eine Zunahme der Festigkeit erzielt werden. Damit einhergehend sind negative Kugelausbildungseigenschaften, die sog. "Dimple-Bildung", bei der Loop-Herstellung. EP 822 264 offenbart ein Verfahren zur Herstellung einer Goldlegierung, die Kalzium enthält.

Die Aufgabe der vorliegenden Erfindung besteht darin, Goldlegierungen mit weiter verbesserter Festigkeit bereitzustellen, bei denen die sonstigen vorteilhaften Eigenschaften des Golds, insbesondere der edle Charakter und die hohe Leitfähigkeit im Wesentlichen erhalten bleiben.

Die Lösung wird im Anspruch gegeben.

Zur Lösung dieser Aufgabe wird Gold im ppm-Bereich mit wenigstens einem der Lanthanoide, Ytterbium oder Europium legiert, ohne gleichzeitig negative Kugelausbildungseigenschaften ("Dimple-Bildung") bei der Loop-Herstellung hinnehmen zu müssen. Hierzu wird die Goldlegierung als homogener Mischkristall ausgebildet, d.h. zusätzliche Phasen, insbesondere auf Europium oder Ytterbium basierend, werden vermieden.

Das Einführen von Europium oder Ytterbium in Gold mittels goldfreier Vorlegierung mit Kalzium, ermöglicht homogene Goldlegierungen mit diesen Lanthanoiden. Damit wiederum wird es ermöglicht, Goldlegierungen mit über 99 Gew.-%, insbesondere über 99,9 Gew.-% Gold, bereitzustellen, deren physikalischen und mechanischen Eigenschaften für Bonddrahtanwendung besonders geeignet sind.

Entscheidend ist hierbei, die bisher nicht mögliche homogene Verteilung von Europium oder Ytterbium als Dotierungselemente in Gold durch homogene Vorlegierungen aus Kalzium und Europium bzw. Ytterbium zu erzielen. Im Gegensatz zu allen anderen Lanthanoiden zeigen Europium und Ytterbium eine vollständige Löslichkeit in Kalzium, gemäß H. Okomoto and T. B. Massalski, Binary Alloys Phase Diagrams, Metal Park, Ohio, 44073, 1987. Bewährt haben sich binäre Vorlegierungen aus Kalzium und Europium, sowie aus Kalzium und Ytterbium.

Somit wird die Goldlegierung als homogener Mischkristall ausgebildet. Bisher unvermeidliche Einschlüsse wenigstens einer weiteren Phase, basierend auf Europium oder Ytterbium werden erfindungsgemäß vermieden. Die Dotierungselemente sind mit 1 bis 1000 ppm, vorzugsweise 2 bis 500 ppm, insbesondere 10 bis 100 ppm, vollständig im Gold gelöst.

Damit wiederum wird es ermöglicht, dotierte Goldstränge und daraus gezogene Gold-Bonddrähte mit Festigkeitswerten herzustellen, die deutlich über jenen von entsprechenden Referenzdrähten liegen.

In bevorzugter Ausführung enthalten die Gold-Bonddrähte als weitere Dotierungszusätze 1 bis 100 ppm Cer bzw. Cer-Mischmetall. Weiter bevorzugt ist die Verwendung von 1 bis 10 ppm Beryllium.

Diese Elemente ermöglichen gemäß C. W. Conti, Gold Bulletin, 1999, 32(2) 39 eine zusätzliche Festigkeitserhöhung des Bonddrahts, bei Erhaltung bzw. Verbesserung günstiger Bondbedingungen hinsichtlich Loop- und Kugelausbildung.

Die neuen Drahtqualitäten haben Zugfestigkeitswerte von ca. 290 N/mm² bei dem Vergleichs-Bruchdehnungswert von 4 % und Pull-Testwerte der aufgebondeten Drahtloops von ca. 20 cN (bei Durchmesser 30 µm).

In allen Fällen wird eine dimple-freie, abgeflammte Kugel (FAB - Free Air Ball) beim Bondprozess beobachtet. (Dimple können negativ die Fügeeigenschaften zwischen Kugel und Substrat beeinflussen.)

### Beispiel

Herstellung von Vorlegierung auf Au-Basis mit Kalzium-, Ytterbium-, Ce-Mischmetall und Be-Dotierungen.

Aus Kalzium und Ytterbium wird zunächst unter Vakuum eine homogene, binäre Vorlegierung mit jeweils 50 % Gewichtsanteilen erschmolzen. Diese Vorlegierung (I) wird nachfolgend zu einer weiteren Vorlegierung (II) mit dem Hauptbestandteil Gold und jeweils 0,5 Gew.-% Kalzium und Ytterbium verdünnt. Gemeinsam mit einer weiteren Gold-Vorlegierung mit Be- und Ce-Mischmetallzusätzen wird diese Vorlegierung II in eine Goldschmelze eingebracht.

Das auf diesem Wege erzeugte Bonddrahtausgangsmaterial besitzt eine Dotierungskonzentration von 25 ppm Kalzium, 25 ppm Ytterbium, 40 ppm Ce-Mischmetall (Ce-M) und 5 ppm Be.

### Festigkeitseigenschaften

Der von oben genanntem Ausgangsmaterial auf 30 µm gezogene Draht (1) wird nach kontinuierlicher Glühung im Temperaturbereich zwischen 450°C und 525°C einer Zugfestigkeitsprüfung unterzogen und mit entsprechend hergestellten Drähten mit variierten Dotierungskonzentrationen Au-Ca-Yb-Ce(M)-Be5 (2) und Au-Ca-Yb-Ce(M) (3) zusätzlich mit einem konventionell hergestellten Standard-Referenzdraht Au-Ca-Ce(M) (4) verglichen.

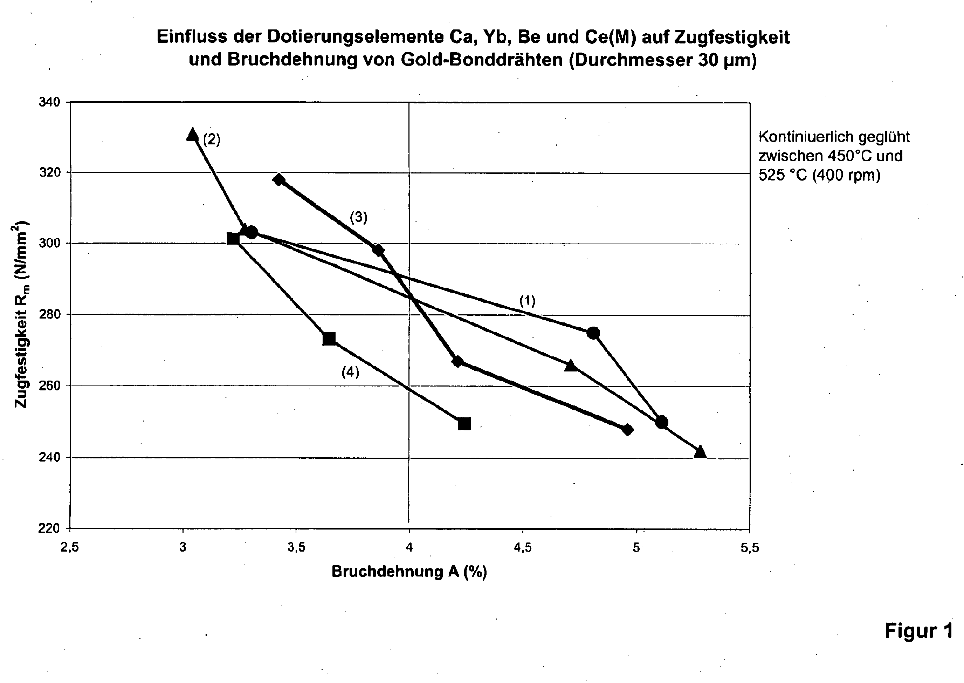

Figur 1 zeigt eine deutlich erhöhte Zugfestigkeit bei 4 % Bruchdehnung der nach dem neuen Verfahren hergestellten Bonddrähte (1) bis (3) gegenüber dem Referenzdraht (4).

Im ersten Fall liegt die Zugfestigkeit bei ca. 290 N/mm² und im letzteren Fall bei 260 N/mm².

### Bondeigenschaften

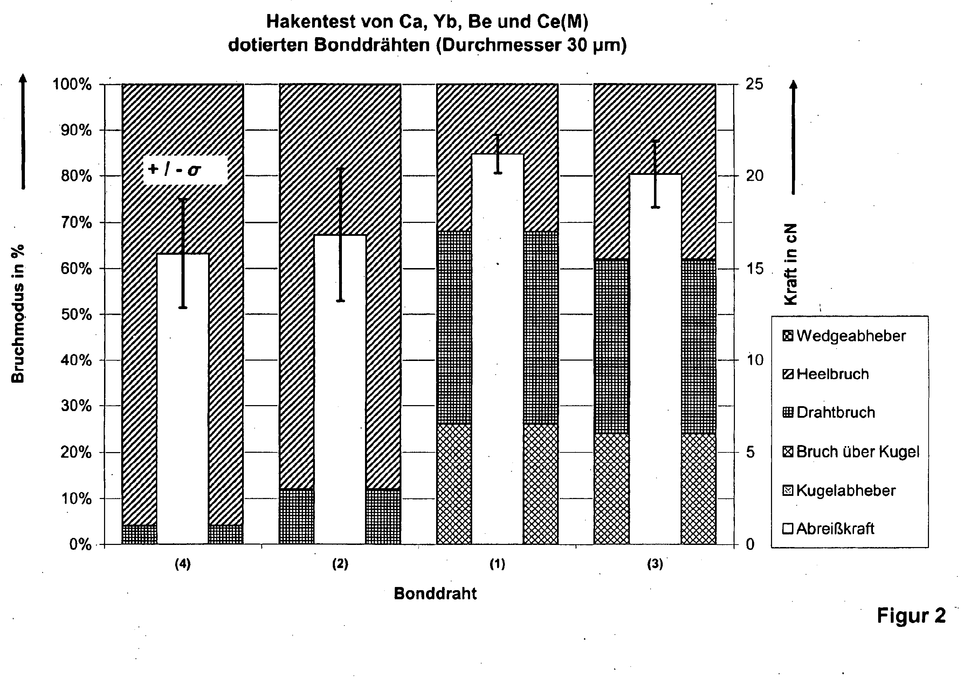

Auf 4 % eingeglühte Drähte werden einem Ball-Wedge-Bondprozess gemäß ASTM, 100 Barr, Harbor Drive, West Conshohocken, Pennsylvania 19428-2959 und G.G. Harman "Wire Bonding in Microelectronics" McGraw-Hill 1997, Seiten 67ff unterzogen. Die Qualität der Bondbarkeit bzw. die Stabilität der Loops werden über den sogenannten Pull- bzw. Hakentest gemäß MIL STD 883F, Microcircuits, Method 2011.7 geprüft. Figur 2 zeigt deutlich erhöhte Pull-Kräfte, der nach dem neuen Verfahren hergestellten Drähte (1) bis (3) gegenüber dem Referenzdraht (4).

Im ersten Fall liegen die Pullkräfte zwischen 17 und 22 cN (beim Beispiel Bonddraht (1) bei 22 cN) gegenüber von 16 cN beim Referenzdraht (4). Weiter zeigen die neuen Drähte einen deutlich erniedrigten Anteil des ungünstigen, die Zuverlässigkeit der Bondverbindung stark einschränkenden Heel-Break-Modus. Er ist bei dem Draht (1) des Beispiels ca. 32 % und beim Referenz-Draht gemäß (4) 97%.

## Patentansprüche

1. Verfahren zur Herstellung einer homogenen Goldlegierung enthaltend Calcium, Europium und/oder Ytterbium, **dadurch gekennzeichnet, dass** eine goldfreie Vorlegierung aus (i) Calcium und (ii) Europium und/oder Ytterbium in Gold gelöst wird.

## Claims

1. Method for producing a homogeneous gold alloy containing calcium, europium and/or ytterbium, **characterised in that** a gold-free pre-alloy made of (i) calcium and (ii) europium and/or ytterbium is dissolved in gold.

## Revendications

1. Procédé de fabrication d'un alliage d'or homogène contenant du calcium, de l'europium et/ou de l'ytterbium, **caractérisé en ce qu'**un alliage préalable exempt d'or constitué (i) de calcium et (ii) d'europium et/ou d'ytterbium est dissous dans de l'or.
